# FASCICULE DE BREVET EUROPEEN

(11) **EP 0 407 251 B1**
(45) Date de publication et mention de la délivrance du brevet: **18.11.1993**
(21) Numéro de dépôt: 90401715.9
(22) Date de dépôt: 19.06.1990
(51) Int. Cl.: H01S 3/19

(54) **Laser semiconducteur à puits quantique**
Quantenstruktur-Halbleiterlaser
Semiconductor quantum well laser

(30) Priorité: 04.07.1989 FR 8908965
(43) Date de publication de la demande: 09.01.1991
(73) Titulaire: THOMSON-CSF, 75008 Paris (FR)
(72) Inventeur: Weisbuch, Claude, F-92402 Courbevoie Cédex (FR); Nagle, Julien, F-92402 Courbevoie Cédex (FR)
(74) Mandataire: Chaverneff, Vladimir

(56) Documents cités:
- APPLIED PHYSICS LETTERS, vol. 51, no. 4, juillet 1987, pages 209-211, New York, US; Y. TOKUDA et al.: "Lasing wavelength of an asymmetric double quantum well laser diode"
- IEEE JOURNAL OF QUANTUM ELECTRONICS, vol. QE-23, no. 6, juin 1987, pages 696-703, New York, US; L.J. MAWST et al.: "Optimization and characterization of index-guided visible A1GaAs/GaAs graded barrier quantum well laser diodes"
- APPLIED PHYSICS LETTERS, vol. 53, no. 1, juillet 1988, pages 1-3, New York, US; M. KITAMURA et al.: "High-power operation in InGaAs separate confinement heterostructure quantum well laser diodes"
- APPLIED PHYSICS LETTERS, vol. 51, no. 2, juillet 1987, pages 78-80, New York, US; K. UOMI et al.: "Ultrahigh relaxation oscillation frequency (up to 30 Ghz) of highly p-doped GaAs/GaALAs multiple quantum well lasers"

## Description

La présente invention se rapporte à un laser semiconducteur à puits quantique.

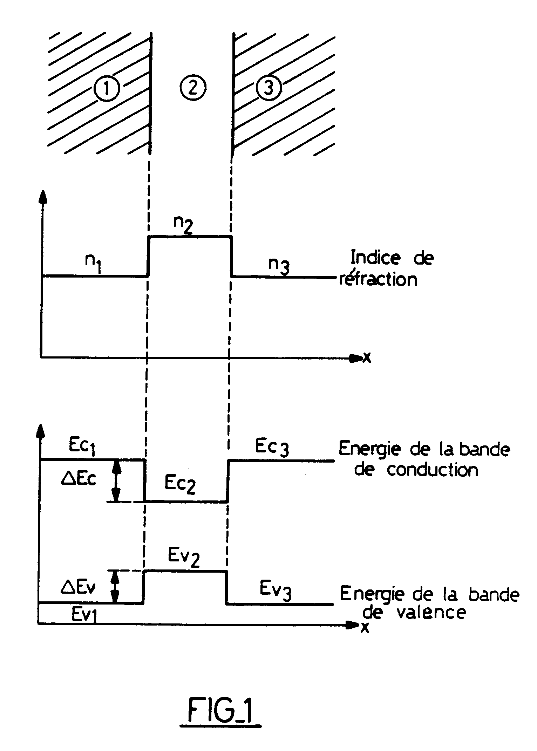

Le principe des lasers à semiconducteurs est bien connu. La structure la plus utilisée est celle du laser à double hétérostructure dont on a représenté la structure, l'indice de réfraction et les niveaux d'énergie sur la figure 1. Grâce au confinement optique induit par la différence d'indice entre les matériaux 1,2 et 3 (n1 à n3 respectivement), on confine l'onde optique du laser dans un espace plus faible que l'extension naturelle de l'onde dans un milieu homogène. Grâce aux discontinuités des niveaux d'énergie dans la bande de conduction (E_{c1} à E_{c3}) et la bande de valence (Eᵥ₁ à Eᵥ₃) les électrons et les trous sont concentrés dans la couche 2, qui agit comme le milieu actif du laser en fournissant du gain à l'onde optique par recombinaison induite des paires électron-trou.

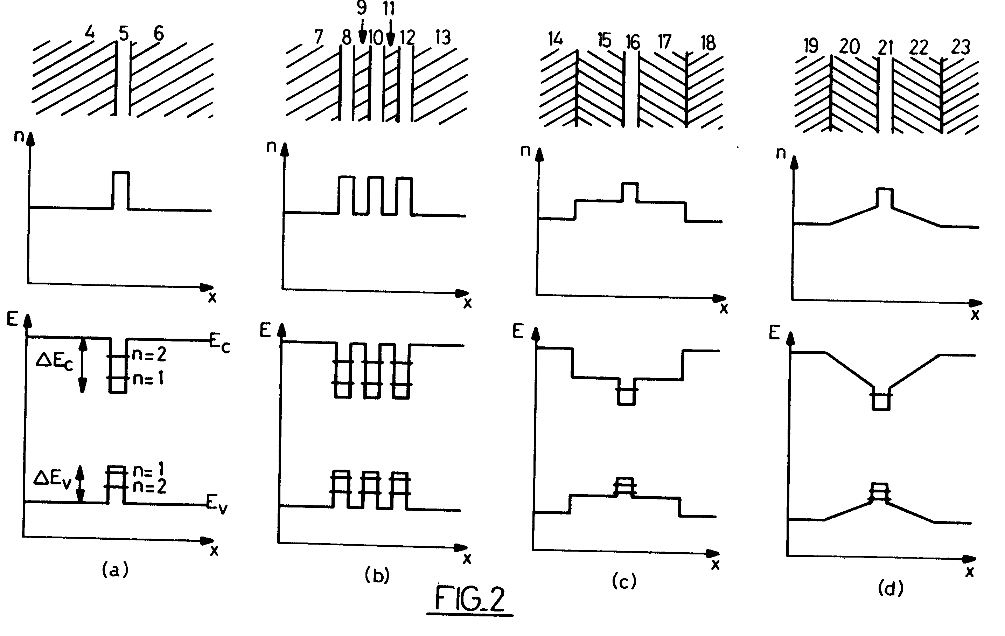

Récemment ont été introduits les lasers à puits quantiques dont les couches actives 2 sont suffisamment étroites pour donner lieu à des phénomènes de quantification. Il a été largement démontré que ces lasers présentent, dans des mises en oeuvre appropriées, des performances meilleures que celles des lasers à double hétérostructure. Quatre réalisations différentes en sont représentées sur la figure 2.

Une modélisation détaillée de tels lasers montre que deux paramètres jouent un rôle essentiel dans la limitation de performances de ces lasers : les puits quantiques ΔE_{c} et ΔEᵥ ne sont pas suffisamment profonds ; les séparations d'énergie entre niveaux quantifiés n = 1 et n = 2 ne sont pas suffisamment grandes, en particulier dans la bande de valence, pour les trous.

Ce dernier paramètre pourrait être amélioré en utilisant des puits très minces, ce que augmenterait la séparation entre niveaux quantiques. Mais dans ce cas, les niveaux se rapprochent tous du bord supérieur des puits quantiques, ce qui amène à un débordement de ces puits, lorsqu'on les remplit par injection électrique d'électrons et de trous, ce qui les rend en fait inutiles.

La solution normale serait de chercher à utiliser comme matériau des puits des composants semiconducteurs à trés faible bande interdite, donc à grandes discontinuités de bandes d'énergie ΔE_{c} et ΔEᵥ, ce qui permettrait d'utiliser des couches très minces sans atteindre le débordement décrit ci-dessus. Cette méthode est cependant impraticable pour des raisons métallurgiques : les matériaux qui ont entre eux des grandes différences de bandes d'énergie possèdent en général des mailles cristallines inégales. Dans ces conditions, lorsque l'on essaie de les faire croître par épitaxie, il se forme dès que l'épaisseur atteint une valeur dite critique, des dislocations nombreuses qui rendent le matériau impropre au fonctionnement du laser.

On connaît d'après le document Applied Physics Letters, vol 51, N° 4, 27.07.87, pages 209-211 une diode laser à puits quantique, utilisant une couche ultrafine pour créer deux puits quantiques de largeurs différentes, afin d'en augmenter le domaine spectral.

La présente invention a pour objet un laser semiconducteur à puits quantique à performances plus élevées que celles des lasers connus, et qui soit facile à réaliser.

Le laser semiconducteur à puits quantique conforme à l'invention comporte au moins une couche ultrafine insérée entre au moins deux couches du puits quantique, cette (ces) couche(s) ultrafine (s) étant, de préférence, en matériau isoélectronique avec le matériau des couches du puits quantique, cette couche étant à chaque fois disposée approximativement à l'endroit d'un extremum d'une fonction d'onde et loin du extremum de la fonction d'onde voisine. L'épaisseur des couches ultrafines est celle d'une ou de quelques monocouches atomiques, en tout cas inférieure à l'épaisseur critique. De façon avantageuse, le matériau de la (des) couche(s) ultrafine(s) est, comme celui des couches du puits quantique, du groupe III-V.

La présente invention sera mieux comprise à la lecture de la description détaillée de plusieurs modes de réalisation, pris à titre d'exemples non limitatifs et illustrés par le dessin annexé, sur lequel :
- la figure 1 déjà citée ci-dessus, est une vue en coupe simplifiée des couches semi-conductrices d'un laser connu à double hétérostructure, avec, en correspondance, des diagrammes d'indice de réfraction, d'énergie dans la bande de conduction, et d'énergie dans la bande de valence,
- la figure 2, déjà citée ci-dessus, représente des vues en coupe simplifiées des couches semi-conductrices de quatre lasers connus à puits quantiques, avec, en correspondance, des diagrammes d'indice de réfraction, d'énergie de la bande de conduction et d'énergie de la bande de valence, et
- les figures 3 à 5 représentent des vues en coupe simplifiées des couches semi-conductrices de deux modes de réalisation d'un laser conforme à l'invention, avec, en correspondance, des diagrammes d'énergie de la bande de conduction de la bande de valence.

Dans la structure de la figure 1, les couches de matériaux 1 et 3 sont souvent de même nature chimique, à l'exception de matériaux dopants permettant d'obtenir les conductivités n et p. L'épaisseur typique de la couche 2 est comprise entre 100 et 200 nm (1000 et 2000 Å).

Les structures (a) à (d) de la figure 2 sont respectivement celles d'un laser à puits quantique simple, d'un laser à puits quantique multiple, d'un laser à puits quantique simple à confinement séparé, et d'un laser à puits quantique simple à confinement optique séparé à gradient d'indice par composition variable du matériau de la cavité optique. Des variantes connues, et non représentées, des structures (c) et (d) se rapportent à des lasers à puits quantiques multiples à confinement séparé.

Dans les structures de la figure 2, les couches 5,8,10,12,16,21 jouent le rôle du milieu actif et sont d'épaisseur typique 3 à 20 nm (30 à 200 Å).

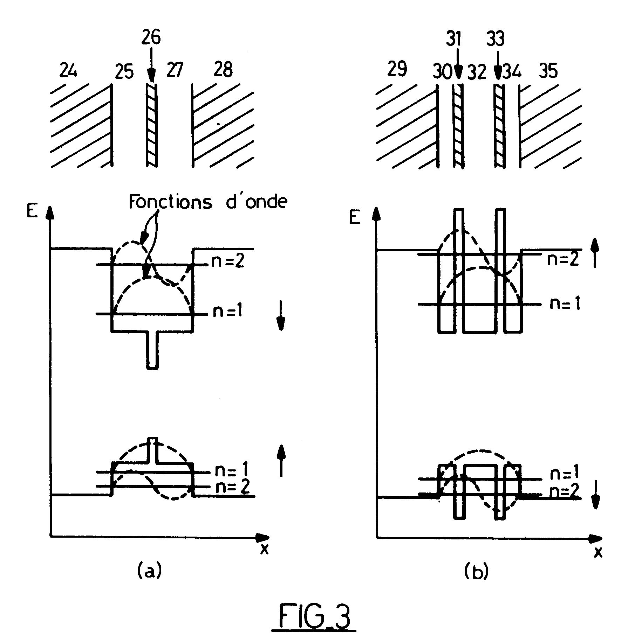

On a représenté en figure 3 des modes de réalisation simples d'une structure conforme à l'invention. En (a), la structure comporte une couche ultrafine 26 insérée au centre du puits quantique, entre les couches 25,27 formant ce puits quantique encadré par les couches de barrière 24,28. La couche ultrafine 26 abaisse le niveau n=1 car la fonction d'onde n=1 interagit fortement avec la couche ultrafine : si celle-ci a des niveaux de bande de conduction et de valence plus bas que ceux du matériau du puits quantique, on abaisse les niveaux d'énergie n=1. Par contre, comme le niveau d'énergie n=2 est de probabilité de présence nulle au centre du puits quantique, comme on le voit d'après les diagrammes de la partie (a) de la figure 3, il n'est pas affecté pour la présence de la couche ultrafine 26 qui est bien localisée au centre de ce puits.

Dans le cas du mode de réalisation de la partie (b) de la figure 3, on insère deux couches ultrafines 31,33 entre les couches de puits quantique 30, 32 et 34, le tout étant entouré par des couches de barrière 29, 35.

Dans ce cas de figure, la position des couches ultrafines 31, 33 correspond approximativement à celle des extremums de la fonction d'onde du niveau n=2. On peut alors modifier de façon importante de ce niveau en changeant beaucoup moins la position du niveau n=1. On pourrait par exemple mettre une couche ultrafine de matériau de niveaux d'énergie plus élevés que ceux du matériau constituant le puits quantique afin d'élever le niveau n=2.

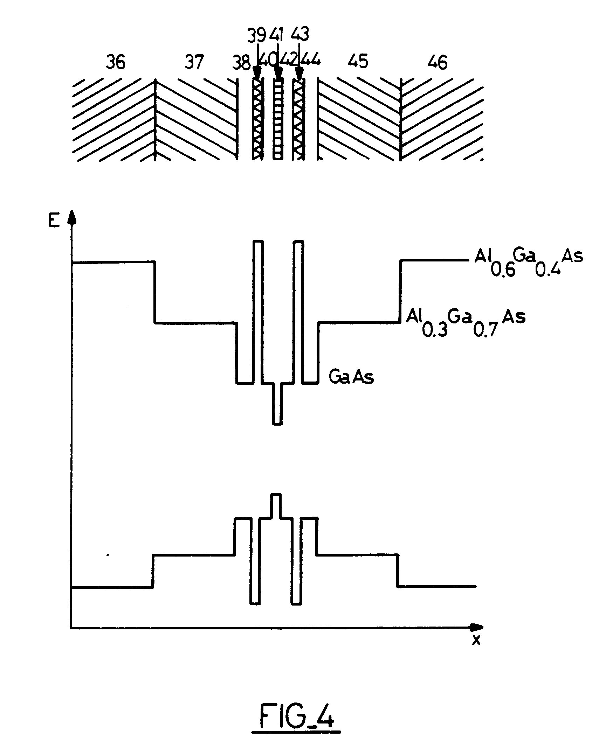

On a représenté en figure 4, un mode de réalisation avantageux de l'invention. La structure de la figure 4 comporte des premières couches de barrière 36, 46 et des secondes couches de barrière 37, 45 enserrées par les premières couches.

Le puits quantique est constitué de quatre couches 38, 40, 42 et 44 séparées par trois couches ultrafines 39, 41, 43.

Selon un mode de réalisation, les couches 36 et 46 sont en Al_{0,6}Ga_{0,4}As et les couches 37 et 45 sont en Al_{0,3}Ga_{0,7}As. Les couches 38, 40, 42 et 44 sont en GaAs. La couche centrale 41 est en InAs et les couches 39 et 43 en AlAs.

On calcule que dans ce mode de réalisation, par rapport au puits quantique simple en GaAs les niveaux n=1 d'électrons et trous sont abaissés de 7meV et 48 meV respectivement, alors que les niveaux n=2 d'électrons et trous sont élevés de 37 meV et 22 meV respectivement pour une couche 41 de InAs d'une épaisseur de 0,3 nm (3Å) et des couches 39 et 43 de AlAs d'une épaisseur de 0.15 nm (1,5 Å) chacune.

Un effet additionnel bénéfique est fourni par la contrainte induite par la différence de maille atomique des matériaux. Elle abaisse encore plus le niveau de trou lourd et élève le niveau de trou léger (pour le cas le plus courant d'un matériau à faible gap de maille atomique supérieure à celle du matériau à grand gap), ce qui conduit à une séparation accrue entre niveaux n=1 de trous lourds et légers : le niveau de trou lourd se trouve alors bien séparé du niveau n=2 de trou lourd par l'effet de la perturbation et du niveau n=1 de trou léger par la contrainte.

Des effets de contrainte peuvent être ajoutés à volonté en utilisant un matériau de puits quantique (couches 25-27, 30-32-34, 38-40-42-44 et 49-51 décrites ci-dessous) contraint par rapport aux couches de confinement optique et au substrat.

Suivant les effets recherchés, on pourra utiliser des orientations cristallines de croissance appropriées, les effets de séparation de niveaux quantiques et de contrainte variant fortement d'une orientation à l'autre. On pourrait ainsi faire coïncider exactement les niveaux de trous lourds et légers, ce qui améliorerait dans certaines conditions les propriétés du laser.

Il est bien entendu que les compositions chimiques et épaisseurs des couches citées ci-dessus ne sont données qu'à titre indicatif, et que toute autre association de matériaux en particulier de matériaux, isoélectroniques pour les couches ultrafines et les couches de puits quantique, est possible puisque la nature ultrafine des couches insérées entre les couches de puits quantiques permet leur croissance épitaxique quasi-parfaite. Certaines combinaisons non-isoélectroniques pourraient aussi convenir.

On a décrit ci-dessus le cas du laser GaAs/GaAlAs comme exemple. Dans le cas des lasers dans le proche infra-rouge, à base le plus souvent de couches en alliages GaInAs, GaInAsP et InP, les paramètres d'optimisation peuvent être différents : les lasers à puits quantique sont souvent limités par la population thermodynamique en électrons des couches de confinement optique (couches 15 et 17, figure 2c) à cause du faible écart en énergie entre le niveau n=1 d'électrons du puits et le niveau d'énergie d'électrons dans ces couches de confinement optique. Le paramètre que l'on cherchera alors à optimiser sera cet écart, et l'on utilisera les matériaux de couche ultra-mince les mieux appropriées à cet égard.

Comme ce sont les niveaux de trous que l'on cherche le plus souvent à séparer, on peut, le cas échéant, prendre un matériau qui élèverait le niveau n=1 d'électrons à cause de niveaux de la bande de conduction plus élevés que dans le puits quantique, mais où un effet plus important aurait lieu dans la bande de valence grâce à une différence d'énergie ΔE_{V} plus importante que dans les exemples décrits ci-dessus.

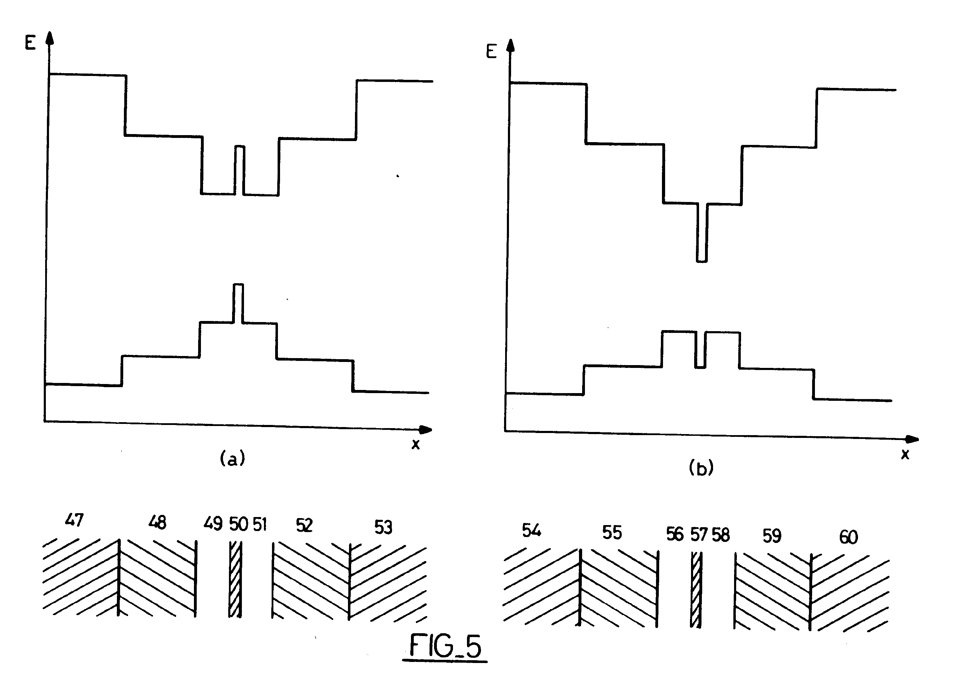

On a représenté en figure 5 un exemple de réalisation. En (a), la structure comporte des couches de barrières extérieures 47, 53 et des couches de barrières intérieures 48, 52. Une couche ultramince 50 est insérée entre deux couches 49, 51 du puits quantique.

En (b) sur la figure 5, on a une structure similaire à celle de (a) : couches de barrières extérieures 54, 60, couches de barrières intérieures 55,59, couches de puits quantique 56,58 et couche ultramince 57.

On peut aussi ajouter des couches suivant le même principe pour contrôler les niveaux quantiques supérieurs mais ce n'est en général pas nécessaire.

On peut associer les couches ultraminces avec des atomes tel que Si, Zn, Mg, ou Be, afin d'associer à l'effet de contrôle des niveaux d'énergie un effet de positionnement du niveau de Fermi des électrons ou des trous.

Les couches étant ultraminces, elles ont peu d'influence sur le confinement de l'onde optique. On les associe donc avec des structures où l'on a pris soin d'optimiser ce confinement, telles que les structures des figures 2(b), 2 (c), 2 (d).

## Revendications

1. Laser semiconducteur à puits quantique caractérisé par le fait qu'il comporte au moins une couche ultrafine (26, 31, 33, 39, 41 43, 50, 57) insérée entre au moins deux couches du puits quantique (25, 27, 30, 32, 34, 38; 40, 42; 44, 49, 51, 56, 58). cette couche étant à chaque fois disposée approximativement à l'endroit d'un extremum d'une fonction d'onde et loin du extremum de la fonction d'onde voisine.

2. Laser selon la revendication 1, caractérisé par le fait que la (les) couche(s) ultrafine(s) est (sont) en matériau isoélectronique avec le matériau des couches du puits quantique.

3. Laser selon la revendication 1 ou 2, caractérisé par le fait que l'épaisseur de la (des) couche(s) ultrafine(s) est inférieure à l'épaisseur critique.

4. Laser selon la revendication 3, caractérisé par le fait que l'épaisseur de la (des) couches ultrafine(s) est celle d'une ou de quelques monocouches atomiques.

5. Laser selon l'une des revendications précédentes, caractérisé par le fait que le matériau de la (des) couche(s) ultrafine(s) est du groupe III-V.

6. Laser selon l'une des revendications précédentes, caractérisé par le fait que l'on ajoute à la (aux) couche(s) ultrafine(s) des atomes dopants choisis parmi Si, Zn, Mg, Be.

7. Laser selon l'une des revendications précédentes, avec une couche ultrafine (26), caractérisé par le fait que cette couche est disposée au milieu de la couche du puits quantique (25, 27).

8. Laser selon l'une des revendications 1 à 6, avec deux couches ultrafines (31, 33), caractérisé par le fait que ces couches sont disposées approximativement à la position des extremums des fonctions d'onde du niveau n=2.

9. Laser selon l'une des revendications 1 à 6, avec trois couches ultrafines, caractérisé par le fait que la couche ultrafine centrale (41) est en InAs et les deux autres en AlAs.

10. Laser selon l'une des revendications 1 à 6, caractérisé par le fait qu'il a une structure à puits quantique simple à confinement séparé.

11. Laser selon l'une des revendications 1 à 6, caractérisé par le fait qu'il a une structure à puits quantique simple à confinement optique séparé à gradient d'indice par composition variable du matériau de la cavité optique.

12. Laser selon l'une des revendications 1 à 6, caractérisé par le fait qu'il à une structure à puits quantique multiple à confinement séparé.

13. Laser selon l'une des revendications 1 à 6, caractérisé par le fait qu'il a une structure à puits quantique multiple à confinement optique séparé à gradient d'indice par composition variable du matériau de la cavité optique.

## Patentansprüche

1. Halbleiterlaser mit Quantensenke, dadurch gekennzeichnet, daß er mindestens eine extrem dünne Schicht (26, 31, 33, 39, 41, 43, 50, 57) enthält, die zwischen mindestens zwei Quanten-senkenschichten (25, 27, 30, 32, 34, 38; 40, 42; 44, 49, 51, 56, 58) eingefügt ist, wobei diese Schicht jedesmal etwa an der Stelle eines Extremwerts einer Wellenfunktion und weit entfernt vom Extremwert der benachbarten Wellenfunktion liegt.

2. Laser nach Anspruch 1, dadurch gekennzeichnet, daß die zumindest eine extrem dünne Schicht aus mit dem Material der Schichten der Quantensenke isoelektronischem Material besteht.

3. Laser nach Anspruch 1 oder 2, dadurch gekennzeichnet, daß die Dicke der zumindest einen extrem dünnen Schicht geringer als die kritische Dicke ist.

4. Laser nach Anspruch 3, dadurch gekennzeichnet, daß die Dicke der zumindest einen extrem dünnen Schicht eine oder einige atomare Einzelschichten beträgt.

5. Laser nach einem der vorhergehenden Ansprüche, dadurch gekennzeichnet, daß das Material der zumindest einen extrem dünnen Schicht aus der Gruppe III-V gebildet wird.

6. Laser nach einem der vorhergehenden Ansprüche, dadurch gekennzeichnet, daß der zumindest einen extrem dünnen Schicht Dotieratome hinzugefügt werden, die aus Si, Zn, Mg, Be ausgewählt sind.

7. Laser nach einem der vorhergehenden Ansprüche mit einer extrem dünnen Schicht (26), dadurch gekennzeichnet, daß diese Schicht in der Mitte der Schicht der Quantensenke (25, 27) liegt.

8. Laser nach einem der Ansprüche 1 bis 6, mit zwei extrem dünnen Schichten (31, 33), dadurch gekennzeichnet, daß diese Schichten etwa an der Stelle der Extremwerte der Wellenfunktionen des Niveaus n = 2 liegen.

9. Laser nach einem der Ansprüche 1 bis 6, mit drei extrem dünnen Schichten, dadurch gekennzeichnet, daß die zentrale extrem dünne Schicht (41) aus InAs und die beiden anderen aus AlAs sind.

10. Laser nach einem der Ansprüche 1 bis 6, dadurch gekennzeichnet, daß er eine einfache Quantensenkenstruktur mit getrennter Einschließung besitzt.

11. Laser nach einem der Ansprüche 1 bis 6, dadurch gekennzeichnet, daß er eine einfache Quantensenkenstruktur mit getrennter optischer Einschließung in Form eines Indexgradienten aufgrund einer variablen Zusammensetzung des Materials des optischen Hohlraums besitzt.

12. Laser nach einem der Ansprüche 1 bis 6, dadurch gekennzeichnet, daß er eine Struktur mit Mehrfachquantensenke und getrennter Einschließung aufweist.

13. Laser nach einem der Ansprüche 1 bis 6, dadurch gekennzeichnet, daß er eine Struktur mit Mehrfachquantensenke und getrennter optischer Einschließung mit Hilfe eines Indexgradienten aufgrund einer variablen Zusammensetzung des Materials des optischen Hohlraums besitzt.

## Claims

1. Quantum-well semiconductor laser, characterised in that it comprises at least one ultrathin layer (26, 31, 33, 39, 41, 43, 50, 57) inserted between at least two layers of the quantum well (25, 27, 30, 32, 34, 38; 40, 42; 44, 49, 51, 56, 58), this layer being located in each case approximately at the place of an extremum in a wave function and far from the extremum in the neighbouring wave function.

2. Laser according to Claim 1, characterised in that the ultrathin layer(s) is (are) made of a material which is isoelectronic with the material of the layers of the quantum well.

3. Laser according to Claim 1 or 2, characterised in that the thickness of the ultrathin layer(s) is less than the critical thickness.

4. Laser according to Claim 3, characterised in that the thickness of the ultrathin layer(s) is that of one or a few atomic monolayers.

5. Laser according to one of the preceding claims, characterised in that the material of the ultrathin layer(s) is of group III-V.

6. Laser according to one of the preceding claims, characterised in that dopant atoms chosen from Si, Zn, Mg, Be are added to the ultrathin layer(s).

7. Laser according to one of the preceding claims, with an ultrathin layer (26), characterised in that this layer is located in the middle of the layer of the quantum well (25, 27).

8. Laser according to one of Claims 1 to 6, with two ultrathin layers (31, 33), characterised in that these layers are located approximately at the position of the extrema in the wave functions of level n=2.

9. Laser according to one of Claims 1 to 6, with three ultrathin layers, characterised in that the central ultrathin layer (41) is made of InAs and the other two of AlAs.

10. Laser according to one of Claims 1 to 6, characterised in that it has a structure with a single quantum well with separate confinement.

11. Laser according to one of Claims 1 to 6, characterised in that it has a structure with a single quantum well with separate graded-index optical confinement using variable composition of the material in the optical cavity.

12. Laser according to one of Claims 1 to 6, characterised in that it has a structure with a multiple quantum well with separate confinement.

13. Laser according to one of Claims 1 to 6, characterised in that it has a structure with a multiple quantum well with separate graded-index optical confinement using variable composition of the material in the optical cavity.
